# DEMANDE DE BREVET EUROPEEN

(11) **EP 4 668 593 A1**
(43) Date de publication de la demande: **24.12.2025**
(21) Numéro de dépôt: 25181569.2
(22) Date de dépôt: 09.06.2025
(51) Int. Cl.: H04B 5/26, H04B 1/04, H04B 5/43, H04B 5/48, H04B 1/18

(54) **DISPOSITIF ELECTRONIQUE A LIAISON SANS FIL**

(30) Priorité: 17.06.2024 FR 2406385
(71) Demandeur: STMicroelectronics International N.V., 1228 Plan-les-Ouates, Geneva (CH)
(72) Inventeur: MONTAUDON, Franck, 38240 MEYLAN (FR); GOULIER, Julien, 38000 GRENOBLE (FR)
(74) Mandataire: Cabinet Beaumont

(57) **Abrégé**

La présente description concerne un dispositif électronique comprenant une antenne (201) et un circuit (202) d'adaptation de l'impédance de l'antenne (201) comprenant des première et deuxième résistances (R201, R202) activables en fonction de la valeur d'un champ reçu par l'antenne (201) et dont les valeurs sont indépendantes de la valeur dudit champ reçu par ladite antenne (201), dans lequel :
- une première borne de ladite première résistance (R201) est reliée à une première borne de ladite antenne (201) ;
- une deuxième borne de ladite deuxième résistance (R202) est reliée à une deuxième borne de ladite antenne (201) différente de ladite première borne.

## Description

### Domaine technique

La présente description concerne de façon générale les circuits et dispositifs électroniques. La présente description se rapporte plus particulièrement à des circuits et dispositifs électroniques adaptés à mettre en oeuvre des liaisons sans fil, comme des communications sans fil et/ou des transferts d'énergie sans fil.

### Technique antérieure

Les liaisons sans fil sont très utilisées de nos jours pour mettre en oeuvre des communications d'informations mais aussi pour effectuer des transferts d'énergie entre deux, ou plus de deux, dispositifs électroniques.

Il serait souhaitable de pouvoir améliorer, au moins en partie, certains aspects des communications sans fil et/ou des transferts d'énergie sans fil.

### Résumé de l'invention

Il existe un besoin pour des dispositifs adaptés à mettre en oeuvre des communications sans fil plus performantes.

Il existe un besoin pour des dispositifs adaptés à mettre en oeuvre des communications sans fil de façon plus précise.

Il existe un besoin pour des dispositifs adaptés à mettre en oeuvre des communications sans fil avec un très grand nombre de terminaux différents.

Il existe, plus particulièrement, un besoin pour des dispositifs adaptés à mettre en oeuvre des communications en champ proche (Near Field Communication, NFC) plus efficaces et plus précises.

Un mode de réalisation pallie tout ou partie des inconvénients des dispositifs électroniques connus mettant en oeuvre une communication sans fil, comme une communication en champ proche.

Un mode de réalisation prévoit un dispositif électronique adapté à mettre en oeuvre une communication sans fil plus efficace et plus précise.

Un mode de réalisation prévoit un dispositif électronique adapté à mettre en oeuvre une communication en champ proche plus efficace et plus précise.

Un mode de réalisation prévoit un dispositif électronique comprenant une antenne et un circuit de commande de l'impédance de l'antenne plus précis.

Un mode de réalisation prévoit, en outre, le procédé de commande de l'impédance de l'antenne d'un tel dispositif.

Un mode de réalisation prévoit un dispositif électronique comprenant une antenne et un circuit d'adaptation de l'impédance de l'antenne comprenant des première et deuxième résistances activables en fonction de la valeur d'un champ reçu par l'antenne et dont les valeurs sont indépendantes de la valeur dudit champ reçu par ladite antenne, dans lequel :
- une première borne de ladite première résistance est reliée à une première borne de ladite antenne ;
- une deuxième borne de ladite deuxième résistance est reliée à une deuxième borne de ladite antenne différente de ladite première borne.

Un autre mode de réalisation prévoit un procédé de communication sans fil entre un terminal et un dispositif comprenant une antenne et un circuit de commande de l'impédance de l'antenne comprenant des première et deuxième résistances activables en fonction de la valeur d'un champ reçu par l'antenne et dont les valeurs sont indépendantes de la valeur dudit champ reçu par ladite antenne, dans lequel :
- une première borne de ladite première résistance est reliée à une première borne de ladite antenne ;
- une deuxième borne de ladite deuxième résistance est reliée à une deuxième borne de ladite antenne différente de ladite première borne.

Selon un mode de réalisation, ladite première résistance est activée quand ledit champ reçu par l'antenne a une amplitude présentant un état bas, et
ladite deuxième résistance est activée quand ledit champ reçu par l'antenne a une amplitude à un état bas.

Selon un mode de réalisation, ladite première résistance est associée à un premier interrupteur commandé par une première tension de commande dépendant dudit champ reçu par ladite antenne, et
ladite deuxième résistance est associée à un deuxième interrupteur commandé par une deuxième tension de commande dépendant dudit champ reçu par ladite antenne.

Selon un mode de réalisation, le premier interrupteur et le deuxième interrupteur sont identiques, et
la première tension de commande et la deuxième tension de commande sont identiques.

Selon un mode de réalisation, la première tension de commande et la deuxième tension de commande sont fournies par un circuit de fourniture d'une tension image de l'amplitude d'un champ radiofréquence reçu par l'antenne.

Selon un mode de réalisation, ledit dispositif comprend un circuit de commande de l'impédance vue par ladite antenne.

Encore un autre mode de réalisation prévoit un système comprenant un dispositif décrit précédemment et un terminal.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
La figure 1 représente, très schématiquement et partiellement sous forme de blocs, un système adapté à mettre en oeuvre une communication sans fil ;
la figure 2 représente plus en détail un mode de réalisation d'une partie d'un dispositif du système de la figure 1 ;
la figure 3 représente deux séries de courbes illustrant le fonctionnement du mode de réalisation de la figure 2 ; et
la figure 4 représente des courbes illustrant plus en détail le fonctionnement du mode de réalisation de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les modes de réalisation décrits ci-après concernent les dispositifs électroniques adaptés à mettre en oeuvre des communications de données sans fil, comme des communications de données en champ proche (Near Field Communication, NFC) ou communications NFC. Une communication en champ proche se base sur l'utilisation d'un champ radiofréquence pour échanger des données, et sur la modulation de la fréquence de ce champ pour encoder des données. Un dispositif électronique adapté à recevoir des données provenant d'une telle communication en champ proche est équipé d'une antenne et d'au moins un circuit d'extraction de signal. Un circuit de gestion de l'impédance de l'antenne, ou circuit de commande de l'impédance de l'antenne, peut aussi être utilisé pour améliorer les performances en réception de signaux du dispositif.

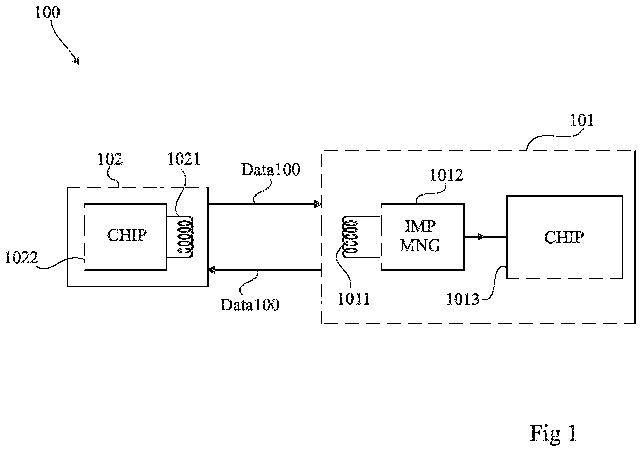

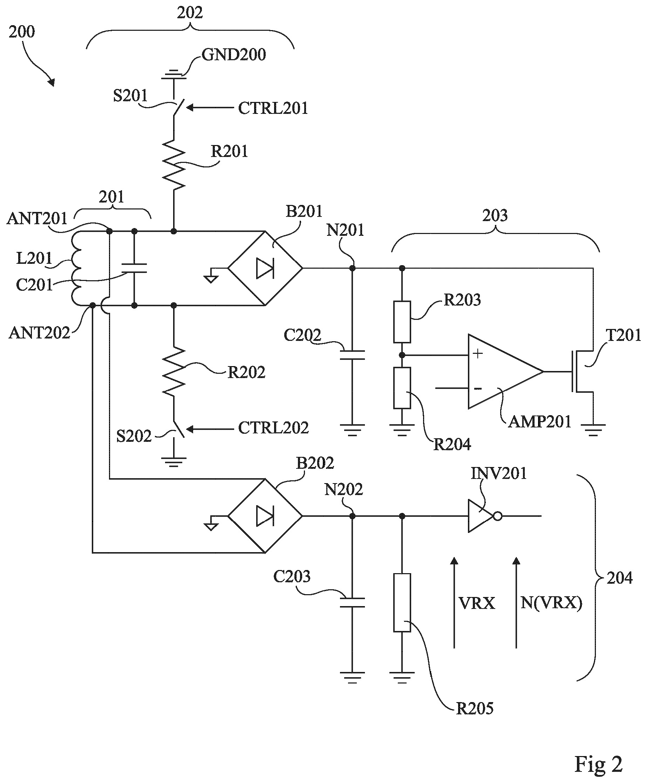

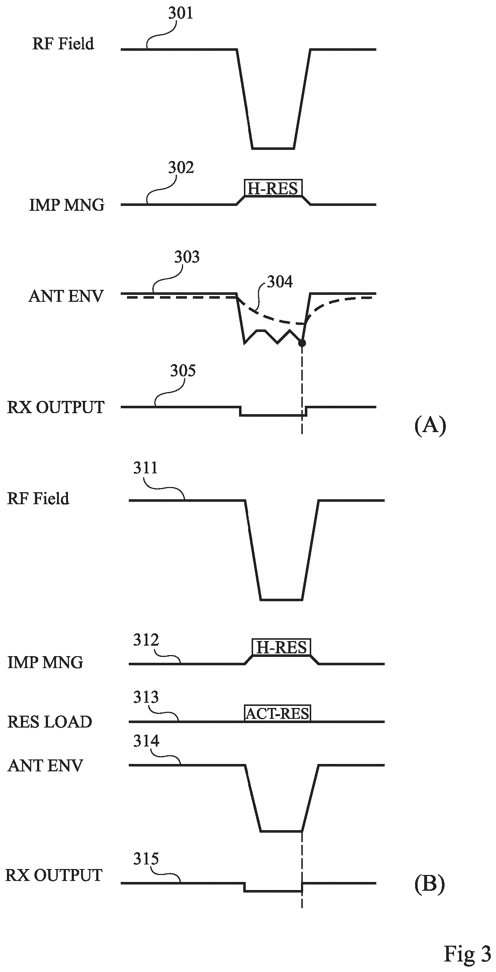

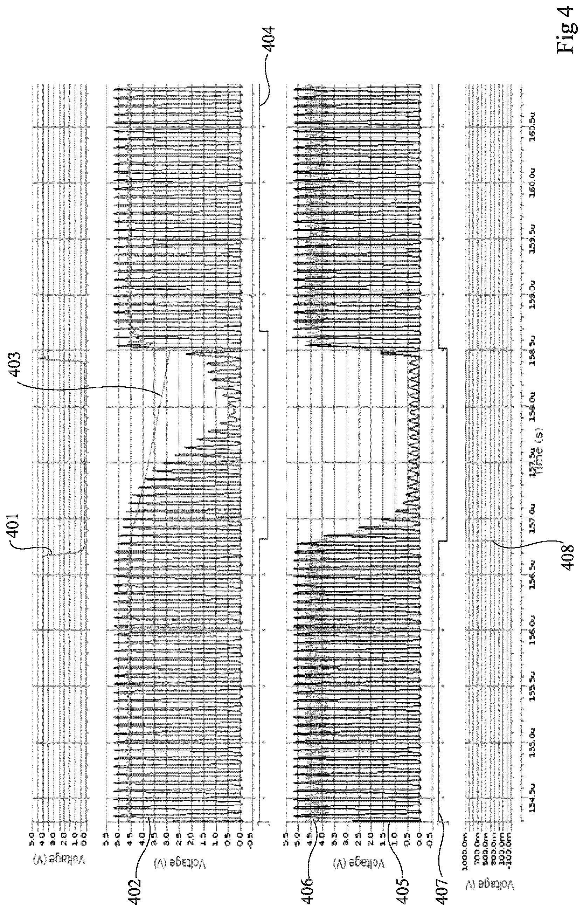

Plus particulièrement, les modes de réalisation décrits ci-après concernent plus particulièrement un dispositif électronique comprenant une antenne et un circuit de commande de l'impédance de l'antenne permettant d'améliorer la précision de la réception d'un signal transmis par une communication en champ proche. Ces modes de réalisation permettent plus précisément d'améliorer la détection d'un front montant du signal reçu. Un tel mode de réalisation est décrit en relation avec les figures 1 et 2. Son fonctionnement est, quant à lui, décrit plus en détail en relation avec les figures 3 et 4.

De plus, les modes de réalisation décrits ci-dessus sont particulièrement adaptés pour être utilisés dans tout type de marchés industriels où une communication sans fil, et, plus particulièrement une communication sans fil utilisant un champ radiofréquence, comme une communication NFC, est utilisée. Plus particulièrement, un tel dispositif adapté à mettre en oeuvre une communication sans fil peut être destiné à :
- le secteur industriel, par exemple dans le domaine de l'électrification automobile ou dans le domaine des systèmes avancés d'aide à la conduite (Advanced Driver Assistance Systems - ADAS) ;
- l'industrie industrielle, par exemple dans le domaine de l'énergie verte, dans le domaine de l'électrification des infrastructures, de l'internet des objets (Internet of Things
- IoT) et des maisons intelligentes (SmartHome), où la consommation d'électricité et d'énergie et l'échange de données sont des éléments clés ; et
- l'industrie de l'électronique personnelle, par exemple dans le domaine de la téléphonie mobile et de l'internet des objets (Internet of Things - IoT), ainsi que dans le domaine des interfaces haut débit.

La figure 1 représente, très schématiquement et partiellement sous forme de blocs, un mode de réalisation d'un système 100 comprenant deux dispositifs électroniques 101 et 102 adaptés à communiquer entre eux en mettant en oeuvre une communication sans fil.

Selon un mode de réalisation, les dispositifs électroniques 101 et 102 sont adaptés à communiquer entre eux des données Data100 en mettant en oeuvre une communication en champ proche, ou communication NFC. Pour cela, chaque dispositif 101, respectivement 102 comprend au moins une antenne 1011, respectivement 1021, représentée en figure 1 par une bobine 1011, respectivement 1021.

Selon un mode de réalisation, le dispositif 101 est adapté à recevoir des données Data100 de la part du dispositif 102. Selon un exemple, le dispositif 101 est, en outre, adapté à fournir des données Data100 au dispositif 102.

Pour cela, selon un mode de réalisation, le dispositif 101 comprend un mode de réalisation d'un circuit de commande 1012 (IMP MNG) de l'impédance de l'antenne 1011. Un exemple de réalisation du circuit 1012 est décrit en détail en relation avec la figure 2. Le dispositif 101 comprend, en outre, des circuits 1013 (CHIP) de traitement de signaux de données reçus et, le cas échéant, des circuits d'envoi de données.

Selon un mode de réalisation, le dispositif 102 est adapté à envoyer les données Data100 au dispositif 101. Selon un exemple, le dispositif 102 est, en outre, adapté à recevoir les données Data100 au dispositif 101.

Selon un exemple, le dispositif 102 comprend des circuits 1022 (CHIP) de traitement de signaux et de données permettant d'envoyer, et le cas échéant de recevoir, des signaux de données.

Lorsque des données Data100 sont envoyées par le dispositif 102 au dispositif 101, le dispositif 102 émet un champ radiofréquence et module l'amplitude de ce champ pour encoder les données Data100. L'antenne 1011 du dispositif 101 reçoit ce champ radiofréquence et décode les données Data100 en relevant les différences d'amplitude du champ radiofréquence.

La figure 2 représente un mode de réalisation d'une partie 200 d'un dispositif électronique du type du dispositif électronique 101 décrit en relation avec la figure 1.

Selon un exemple, la partie 200 comprend une antenne 201 formé par un circuit de type LC en parallèle. Plus particulièrement, l'antenne 201 comprend une bobine L201 et un condensateur C201 reliés, de préférence connectés, en parallèle entre eux. Ainsi, une première borne ANT201 de l'antenne 201 est reliée, de préférence connectée, à une première borne de la bobine L201 et à une première borne du condensateur C201, et une deuxième borne ANT202 de l'antenne 201 est reliée, de préférence connectée, à une deuxième borne de la bobine L201 et à une deuxième borne du condensateur C201.

Selon un mode de réalisation, la partie 200 comprend, en outre, un circuit 202 d'adaptation de l'impédance de l'antenne 201. Le circuit 202 comprend deux résistances R201 et R202 qui sont activables en fonction d'une valeur de tension reçue par l'antenne 201.

Selon un exemple, une première borne de la résistance R201 est reliée, de préférence connectée, à la première borne ANT201 de l'antenne 201, et une deuxième borne de la résistance R201 est reliée à un noeud GND200 fournissant un potentiel de référence, par exemple la masse. Pour être activable, la résistance R201 est associée à un interrupteur S201 commandé par une tension de commande CTRL201. Selon un exemple, une première borne de l'interrupteur S201 est reliée, de préférence connectée, à la deuxième borne de la résistance R201, et une deuxième borne de l'interrupteur S201 est reliée, de préférence connectée, au noeud GND200. Selon un mode de réalisation, les résistances R201 et R202 ont des valeurs de résistance, de résistivité ou d'impédance, fixe et totalement indépendante de l'amplitude du champ radiofréquence reçu par l'antenne 201.

Selon un exemple, une première borne de la résistance R202 est reliée, de préférence connectée, à la deuxième borne ANT202 de l'antenne 202, et une deuxième borne de la résistance R202 est reliée au noeud GND200. Pour être activable, la résistance R202 est associée à un interrupteur S202 commandé par une tension de commande CTRL202. Selon un exemple, une première borne de l'interrupteur S202 est reliée, de préférence connectée, à la deuxième borne de la résistance R202, et une deuxième borne de l'interrupteur S202 est reliée, de préférence connectée, au noeud GND200.

Selon un exemple préféré, les tensions de commande CTRL201 et CTRL202 commandent l'ouverture et la fermeture des interrupteurs S201 et S202 en même temps. Selon un mode de réalisation, les interrupteurs S201 et S202 sont identiques et les tensions de commande CTRL201 et CTRL202 sont également identiques.

Selon un exemple, la partie 200 comprend, en outre, un circuit redresseur de tension B201 permettant de redresser une tension fournie par l'antenne 201. Selon un exemple, le circuit redresseur de tension est un pont de diodes comprenant, par exemple, quatre diodes. Un montage en pont de diodes est un exemple de circuit redresseur de tension bien connu de la personne du métier, il n'est donc pas décrit en détail. Ainsi, un premier noeud d'entrée du circuit B201 est relié, de préférence connecté, à la première borne ANT201 de l'antenne 201, et un deuxième noeud d'entrée du circuit B201 est relié, de préférence connecté, à la deuxième borne ANT202 de l'antenne 201. Un premier noeud de sortie du circuit B201 est relié, de préférence connecté, à un noeud N201, et un deuxième noeud de sortie du circuit B201 est relié, de préférence connecté, au noeud GND200.

Selon un exemple, la partie 200 comprend, en outre, un condensateur de filtrage C202. Selon un exemple, une première borne du condensateur C202 est reliée, de préférence connectée, au noeud N201, et une deuxième borne du condensateur C202 est reliée, de préférence connectée, au noeud GND200.

Selon un exemple, la partie 200 comprend, en outre, un circuit 203 de commande de l'impédance vue par ladite antenne 201. Selon un exemple, le circuit 203 permet d'adapter l'impédance du noeud N201. Selon un exemple, le circuit 203 comprend deux résistances R203 et R204, un comparateur de tension AMP201 et un transistor T201. Les deux résistances R203 et R204 sont reliées en série entre le noeud N201 et le noeud GND200. Selon un exemple, une première borne de la résistance R203 est reliée, de préférence connectée, au noeud N201. Une deuxième borne de la résistance R203 est reliée, de préférence connectée, à une première borne de la résistance R204. Une deuxième borne de la résistance R204 est reliée, de préférence connectée, au noeud GND200. Une première borne d'entrée + du comparateur AMP201 est reliée, de préférence connectée, au noeud milieu entre les résistances R203 et R204. Une deuxième borne d'entrée - du comparateur AMP201 reçoit un potentiel de référence Vref. Une borne de sortie du comparateur AMP201 est reliée, de préférence connectée, à une borne de commande du transistor T201. Une première borne de conduction du transistor T201 est reliée, de préférence connectée, au noeud N201, et une deuxième borne de conduction du transistor T201 est reliée, de préférence connectée, au noeud GND200. Selon un exemple, le transistor T201 est un transistor est un transistor à effet de champ à grille métal-oxyde (metal-oxide-semiconductor field-effect transistor), ou transistor MOSFET, ou transistor MOS. De plus, le transistor T201 est un transistor MOS à canal N, ou transistor MOS de type N, ou transistor NMOS.

Selon un exemple, la partie 200 comprend, en outre, un circuit 204 de fourniture d'une tension image de l'amplitude d'un champ radiofréquence reçu par l'antenne 201. Selon un exemple, le circuit 204 comprend :
- un circuit redresseur de tension B202 du type du circuit redresseur de tension B201 décrit précédemment ;
- un circuit de type RC parallèle, comprenant un condensateur C203 et une résistance R205 ; et
- un circuit inverseur INV201.

Ainsi, un premier noeud d'entrée du circuit B202 est relié, de préférence connecté, à la première borne ANT201 de l'antenne 201, et un deuxième noeud d'entrée du circuit B202 est relié, de préférence connecté, à la deuxième borne ANT202 de l'antenne 201. Un premier noeud de sortie du circuit B202 est relié, de préférence connecté, à un noeud N202, et un deuxième noeud de sortie du circuit B202 est relié, de préférence connecté, au noeud GND200.

Une première borne du condensateur C203 est reliée, de préférence connectée, au noeud N202, et une deuxième borne du condensateur C203 est reliée, de préférence connectée, au noeud GND200. Une première borne de la résistance R205 est reliée, de préférence connectée, au noeud N202, et une deuxième borne de la résistance R205 est reliée, de préférence connectée, au noeud GND200. Une tension VRX représentant une image lissée de la tension fournie par l'antenne 201 est fournie entre les noeuds N202 et GND200.

Une borne d'entrée du circuit inverseur INV201 est reliée, de préférence connectée, au noeud N202. Une tension N(VRX) représentant une image lissée et inversée de la tension fournie par l'antenne 201 est fournie entre la borne de sortie du circuit inverseur INV201 et le noeud GND200.

Le fonctionnement de la partie 200 est décrit en relation avec la figure 3.

La figure 3 comprend deux séries (A) et (B) de graphiques illustrant le fonctionnement de la partie 200 de dispositif électronique décrite en relation avec la figure 2.

Plus précisément, la série (A) illustre le fonctionnement d'un circuit du type de la partie 200 décrite en relation avec la figure 2 mais ne comprenant pas le circuit 202 d'adaptation de l'impédance de l'antenne. La série (B) illustre le fonctionnement de la partie 2 décrite en relation avec la figure 2. La comparaison des séries (A) et (B) met en exergue les avantages de l'utilisation du circuit 202 d'adaptation de l'impédance de l'antenne.

Plus particulièrement, la série (A) comprend :
- un graphique 301 (RF Field) représentant une amplitude d'un champ radiofréquence reçu par l'antenne 201 de la partie 200 ;
- un graphique 302 (IMP MNG) représentant des modes de fonctionnement du circuit de gestion d'impédance 203 de la partie 200 ;
- des graphiques 303 (ANT ENV) et 304 représentant une tension image d'un champ radiofréquence reçu par l'antenne 201 ; et
- un graphique 305 (RX OUTPUT) représentant une donnée transmise par le champ radiofréquence.

De plus, la série (B) comprend :
- un graphique 311 (RF Field) représentant une amplitude d'un champ radiofréquence reçu par l'antenne 201 de la partie 200 ;
- un graphique 312 (IMP MNG) représentant des modes de fonctionnement du circuit de gestion d'impédance 203 de la partie 200 ;
- un graphique 313 (RES LOAD) représentant des modes de fonctionnement du circuit 202 ;
- un graphique 314 (ANT ENV) représentant une tension image d'un champ radiofréquence reçu par l'antenne 201 ; et
- un graphique 315 (RX OUTPUT) représentant une donnée transmise par le champ radiofréquence.

Les graphiques 301 et 311 montrent que le champ radiofréquence reçu par l'antenne 201 a une amplitude qui présente, dans un premier temps, un état haut, puis, dans un deuxième temps, un état bas, et pour finir, dans un troisième temps, un état haut. On parle d'état haut, lorsque l'amplitude est supérieure à une première valeur seuil. On parle d'état bas, lorsque l'amplitude est inférieure à une deuxième valeur seuil inférieure à la première valeur seuil.

Lorsque le champ radiofréquence est à un état bas, le circuit 203 de gestion de l'impédance passe dans un mode haut impédance (H-RES), puisque la tension recueillie par l'antenne est inférieure à la tension de référence. Cela est illustré par les graphiques 302 et 312.

En particulier, dans le cas de la série (A), la tension image du champ reçu par l'antenne passe, quand le champ est à un état bas, à un état bas. Cependant, les graphiques 303 et 304 montrent que cette tension peut présenter des phénomènes d'oscillations à l'état bas qui peuvent fausser la détection des données transmises par le champ radiofréquence. Autrement dit, cet effet d'oscillations peut rendre la détection d'un front montant imprécise, et provoquer des retards de détection. Le graphique 303 montre un phénomène d'oscillations apparaissant sur une tension fournie par un circuit du type du circuit 204 décrit en relation avec la figure 2. Le graphique 304 illustre, par des pointillés, la valeur de cette tension qui doit être prise en compte pour obtenir les données transmises par le champ radiofréquence.

Dans le cas de la série (B), le graphique 313 indique que, lorsque le champ radiofréquence est à un état bas, le circuit 204 active les résistances R201 et R202 (ACT-RES). En activant ces résistances, l'impédance de l'antenne est fixée à une valeur haute, ce qui a pour effet de réduire, voire d'empêcher, l'apparition de phénomène d'oscillation au niveau de la tension VRX.

Cette avantage est visible en comparant l'instant du front montant illustré par les graphiques 305 et 315.

La figure 4 est un ensemble de courbes illustrant en outre le fonctionnement de la partie 200 décrite en relation avec la figure 2.

Les courbes de la figure 4 ont été obtenues par les inventeurs pendant une phase de réalisation de test. La figure 4 met en exergue les avantages de l'utilisation du circuit 202 d'adaptation de l'impédance de l'antenne.

La figure 4 comprend :
- une courbe 401 représentant l'amplitude d'un champ radiofréquence reçu par l'antenne de la partie 200 ;
- une courbe 402 de la tension fournie, à réception du champ radiofréquence, par une antenne d'un circuit ne comprenant pas de circuit 202 ;
- une courbe 403 représentant la valeur de la tension de la courbe 402 qui doit être prise en compte pour obtenir les données transmises par le champ radiofréquence ;
- une courbe 404 représentant un signal de données de sortie obtenue à partir de la tension de la courbe 402 ;
- une courbe 405 la tension fournie, à réception du champ radiofréquence, par une antenne 201 de la partie 200 de la figure 2 comportant le circuit 202 ;
- une courbe 406 représentant la valeur de la tension de la courbe 405 qui doit être prise en compte pour obtenir les données transmises par le champ radiofréquence ;
- une courbe 407 représentant un signal de données de sortie obtenue à partir de la tension de la courbe 405 ; et
- une courbe 408 représentant l'évolution d'une tension de commande du circuit 202.

Comme les deux séries (A) et (B) de la figure 3, les courbes montrent que l'utilisation d'un circuit du type du circuit 202 permet de limiter les phénomènes d'oscillations de l'amplitude de la tension recueillie par l'antenne quand la tension est à l'état bas, et permet donc de rendre la détection d'un front montant plus précise.

Il est à noter que la détection d'un front montant est une fonctionnalité importante, en particulier, lors de la mise en oeuvre d'une communication en champ proche utilisant un protocole de communication de type A. Dans ce cas, la détection d'un front montant pendant une transmission de données peut permettre de démarrer un compteur qui permet de mesurer la durée entre des messages échangés. Avoir un dispositif capable de détecter plus précisément un front montant permet, par exemple, d'augmenter sa compatibilité avec d'autres dispositifs électroniques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique (101) comprenant une antenne (1011 ; 201) et un circuit (202) d'adaptation de l'impédance de l'antenne (1011 ; 201) comprenant des première et deuxième résistances (R201, R202) activables en fonction de la valeur d'un champ reçu par l'antenne (1011 ; 201) et dont les valeurs sont indépendantes de la valeur dudit champ reçu par ladite antenne (1011 ; 201), dans lequel :
- une première borne de ladite première résistance (R201) est reliée à une première borne de ladite antenne (1011 ; 201) ;
- une deuxième borne de ladite deuxième résistance (R202) est reliée à une deuxième borne de ladite antenne (1011 ; 201) différente de ladite première borne.

2. Procédé de communication sans fil entre un terminal et un dispositif comprenant une antenne (1011 ; 201) et un circuit de commande de l'impédance de l'antenne (1011 ; 201) comprenant des première et deuxième résistances (R201, R202) activables en fonction de la valeur d'un champ reçu par l'antenne (1011 ; 201) et dont les valeurs sont indépendantes de la valeur dudit champ reçu par ladite antenne (1011 ; 201), dans lequel :
- une première borne de ladite première résistance (R201) est reliée à une première borne de ladite antenne (1011 ; 201) ;
- une deuxième borne de ladite deuxième résistance (R202) est reliée à une deuxième borne de ladite antenne (1011 ; 201) différente de ladite première borne.

3. Dispositif selon la revendication 1, ou procédé selon la revendication 2, dans lequel ladite première résistance (R201) est activée quand ledit champ reçu par l'antenne (1011 ; 201) a une amplitude présentant un état bas, et
ladite deuxième résistance (R202) est activée quand ledit champ reçu par l'antenne (1011 ; 201) a une amplitude à un état bas.

4. Dispositif selon la revendication 1 ou 3,ou procédé selon la revendication 2 ou 3, dans lequel ladite première résistance (R201) est associée à un premier interrupteur (S201) commandé par une première tension de commande (CTRL201) dépendant dudit champ reçu par ladite antenne (1011 ; 201), et
ladite deuxième résistance (R202) est associée à un deuxième interrupteur (S202) commandé par une deuxième tension de commande (CTRL202) dudit champ reçu par ladite antenne (1011 ; 201).

5. Dispositif ou procédé selon la revendication 4, dans lequel le premier interrupteur (S201) et le deuxième interrupteur (S2002) sont identiques, et
la première tension de commande (CTRL201) et la deuxième tension de commande (CTRL202) sont identiques.

6. Dispositif ou procédé selon la revendication 4 ou 5, dans lequel la première tension de commande (CTRL201) et la deuxième tension de commande (CTRL202) sont fournies par un circuit de fourniture (204) d'une tension image de l'amplitude d'un champ radiofréquence reçu par l'antenne (201).

7. Dispositif selon l'une quelconque des revendications 1, 3 à 6, ou procédé selon l'une quelconque des revendications 2 à 6, dans lequel ledit dispositif comprend un circuit de commande (203) de l'impédance vue par ladite antenne (1011 ; 201).

8. Système comprenant un dispositif selon l'une quelconque des revendications 1, 3 à 7 et un terminal.
